# EUROPEAN PATENT APPLICATION

(11) **EP 2 166 599 A1**
(43) Date of publication of application: **24.03.2010**
(21) Application number: 08763893.8
(22) Date of filing: 21.05.2008
(51) Int. Cl.: H01M 4/04

(54) **METHOD OF MANUFACTURING ELECTRODE FOR NONAQUEOUS ELECTROLYTE SECONDARY BATTERY**

(30) Priority: 12.06.2007 JP 2007154781; 25.04.2008 JP 2008114991
(71) Applicant: Panasonic Corporation, Kadoma-shi Osaka 571-8501 (JP)
(72) Inventor: Nagata,Kaoru Intellectual Property Rights, Osaka 540-6207 (JP); Otsuka,Takashi Intellual Property Rights, Osaka 540-6207 (JP)
(74) Representative: TBK-Patent
(86) International application number: PCT/JP2008/001272
(87) International publication number: WO 2008/152772

(57) **Abstract**

A method for producing an electrode for a non-aqueous electrolyte secondary battery, the method comprising the steps of (a) generating a thermal plasma, (b) supplying a raw material of active material into the thermal plasma, and (c) depositing particles produced in the thermal plasma on a surface of a current collector to give an active material layer.

## Description

### TECHNICAL FIELD

The present invention relates to a highly productive method for producing an electrode having a high energy density for a non-aqueous electrolyte secondary battery.

### BACKGROUND ART

In recent years, electronic devices such as personal computers and cellular phones become more portable at a rapid pace. To be used as the power sources for these electronic devices, high capacity secondary batteries small in size and light in weight have been increasingly demanded. For this reason, non-aqueous electrolyte secondary batteries, which have a possibility of achieving a higher energy density, have been widely studied.

In order to achieve higher energy densities of non-aqueous electrolyte secondary batteries, attempts have been made to develop an active material with high capacity. Further, various approaches have been made in order to improve the active material density (packing rate) in an electrode. For example, in order to improve the active material density in an electrode, one proposal suggests directly depositing an active material on the surface of a current collector, without using a conducive material and a resin binder, to form a closely packed active material layer. Furthermore, for the reason that the raw material of active material is expensive, approaches for reducing the processing costs have been made.

Patent Document 1 suggests, in order to provide an electrode having a high active material density, directly depositing a positive electrode active material LiCoO₂ on the surface of a current collector by electron cydotron resonance sputtering, and discloses an active material layer having a thickness of about 2.6 µm for an electrode for use in an all-solid battery. The film growth rate by RF-sputtering is 2.4 nm/min, while the film growth rate by electron cydotron resonance sputtering is as high as about 16.6 nm/min. The crystallinity of the active material produced by electron cydotron resonance sputtering is comparatively higher than that by RF-sputtering.

Patent Document 2 suggests a method of synthesizing nanopartides with reduced processing costs. For example, nanopartides of LiMn₂O₄ are synthesized by supplying a solution containing Li and a solution containing transition metal Mn to a CO₂ laser simultaneously with ethylene gas, and allowing the combustion reaction to proceed therein. The nanoparticles are then mixed with a conductive material and a resin binder. The mixture is applied onto a current collector, or the nanoparticles are directly deposited on a current collector, to form an electrode.

Patent Document 3 suggests forming an active material layer containing Si as a negative electrode active material on the surface of a current collector by vapor deposition, sputtering, CVD, and other methods.

Non-patent Document 1 discloses forming a LiTa₁₋ₓNbₓO₃ film to be used in an optical element device such as an optical modulator by CVD utilizing thermal plasma. For a raw material, LiNb(OR)₆ and LiTa(OR)₆ are used.

Patent document 4 suggests reforming the carbon surface with boron by utilizing thermal plasma. Specifically, a raw material comprising carbon or an organic material is fed into a plasma including a boron-containing compound, thereby to perform a deaning or surface reforming of the carbon. As a result, the irreversible capacity of the carbon serving as a negative electrode active material is reduced, and thus the cycle characteristics are improved.
Patent Document 1: Japanese Laid-Open Patent Publication No. 2007-5219
Patent Document 2: US Patent Publication No. 6,136,287
Patent Document 3: Japanese Laid-Open Patent Publication No. 2006-260928
Patent Document 4: Japanese Laid-Open Patent Publication No. 2006-260847
Non-patent Document 1: T. Majima et al., Journal of Crystal Growth, vol.220, p.336 (2000)

### Disclosure of the Invention

### Problem to be Solved by the Invention

Patent Document 1 relates to a method of produdng a thin film electrode for use in an all-solid battery and the like. The active material layer in an electrode for a non-aqueous electrolyte secondary battery generally has a thickness of 10 µm or more, for example, about 40 µm. The film growth rate by electron cydotron resonance sputtering disclosed in Patent Document 1, although being higher than that by RF-sputtering, is not high enough to form an active material layer having a general thickness.

As disclosed in Patent Document 2, in applying the synthesized nanoparticles, a high level of dispersion technique is required. It is considered therefore that the processing costs cannot be sufficiently reduced. It is further considered that the method of Patent Document 2 fails to provide a sufficient adhesion between the active material and the current collector because the energy possessed by the particles is comparatively small.

In using vapor deposition, sputtering, CVD, and other methods as suggested by Patent Document 3, in order to obtain an active material layer with high crystallinity, annealing of the active material layer is required. Moreover, when the active material layer is formed by vapor deposition, the adhesion between the active material layer and the current collector tends to be reduced.

Patent document 4 suggests performing a deaning or surface reforming of the active material by utilizing thermal plasma, but does not disclose synthesizing an active material or forming an electrode.

Non-patent Document 1 relates to CVD in which a liquid raw material is reacted by means of thermal plasma, and provides a dosely-packed film. In the dosely-packed film, the ion-conducting channels indispensable for an electrode are hardly formed. For this reason, if the film thickness is increased, the electrochemical reaction is difficult to proceed.

### Means for Solving the Problem

The present invention intends to provide a method for produdng an electrode for a non-aqueous electrolyte secondary battery, the method being capable of simplifying the process and providing a high capacity battery.

The method for produdng an electrode for a non-aqueous electrolyte secondary battery of the present invention indudes the steps of (a) generating a thermal plasma, (b) supplying a raw material of active material into the thermal plasma, and (c) depositing particles produced in the thermal plasma on a surface of a current collector to give an active material layer.

In the step (a), the thermal plasma is preferably generated in an atmosphere containing at least one gas selected from the group consisting of argon, helium, oxygen, hydrogen, and nitrogen.
The atmosphere for generating the thermal plasma preferably has a pressure of 10² to 10⁶ Pa.
In the step (a), the thermal plasma is preferably generated by applying a high frequency to a coil from an RF power source. Here, the voltage to be applied to the coil is not particularly limited, but is preferably 1000 Hz or more.
In the present invention, the raw material can be supplied in a powder state into the thermal plasma.

For the raw material, for example, the following materials may be used:
(i) a raw material containing a transition metal compound;
(ii) a raw material containing a transition metal compound and a lithium compound;
(iii) a raw material containing a lithium-containing transition metal oxide; and
(iv) a raw material containing at least one selected from the group consisting of Si, Sn, and Pb.

Examples of the transition metal compound indude a nickel compound, a cobalt compound, a manganese compound and an iron compound. These may be used alone or in combination of two or more.

Examples of the lithium-containing transition metal oxide indude LiₓNi_{y}Co_{1-y-z}Al_{z}O₂, LiₓNi_{y}Mn_{1-y}O₂, LiₓNi_{y}Fe_{1-y}O₂, LiₓNi_{1/3}Mn_{1/3}Co_{1/3}O₂, LiₓMn₂O₄, LiNbO₃, LiₓFe_{y}Mn_{1-y}PO₄, and LiₓCoPO₄, where 0.8 ≤ x ≤ 1.5, 0 ≤ y ≤ 1, and 0 ≤ z ≤ 0.2. These may be used alone or in combination of two or more.

Examples of the raw material containing at least one selected from the group consisting of Si, Sn, and Pb indude SnO_{α}, SiO_{α}, and PbO_{α}, where 0 ≤ α < 2. These may be used alone or in combination of two or more. In addition, for example, Nb₂O₅, V₂O₅, Li_{4/3}Ti_{5/3}O₄, and MoO₂ are preferably used as the raw material.

The structure of the active material layer can be controlled by the supply rate of the raw material. It is preferable, therefore, to obtain information in advance on a relationship between a supply rate of the raw material into the thermal plasma and a structure of an active material layer. In the step (b), it preferable to control the supply rate of the raw material on the basis of the obtained information.

The structure of the active material layer can be controlled by the temperature of the thermal plasma in a vicinity of the current collector. It is preferable, therefore, to obtain information in advance on a relationship between a temperature of the thermal plasma in a vicinity of the current collector and a structure of an active material layer. In the step (a), it preferable to control the temperature of the thermal plasma in a vicinity of the current collector on the basis of the obtained information.

### Effect of the Invention

According to the present invention, it is possible to provide a high capacity electrode for a non-aqueous electrolyte secondary battery in a highly productive manner at low cost. According to the present invention, it is possible to efficienfly provide an active material layer that does not contain a resin binder for bonding the active material to the current collector

### Brief Description of the Drawings

FIG 1 is a schematic cross-sectional view showing one example of a film forming apparatus;
FIG 2 is a schematic cross-setional view of a laminated battery being one example of a non-aqueous electrolyte secondary battery;
FIG. 3 is a schematic cross-sectional view of a coin battery being one example of a non-aqueous electrolyte secondary battery;
FIG. 4 is a plot of X-ray diffraction patterns of positive electrode active material layers of Example 3 and Comparative Example 2;
FIG 5 is an electron micrograph of the surface of an active material layer obtained in Example 3;
FIG. 6 is an electron micrograph of the surface of an active material layer obtained in Example 4;
FIG 7 is an electron micrograph of the surface of an active material layer obtained in Example 5;
FIG 8 is an electron micrograph of the surface of an active material layer obtained in Comparative Example 2; and
FIG. 9 is an electron micrograph of the surface of an active material layer obtained in Comparative Example 3.

### Best Mode for Carrying Out the Invention

The method for producing an electrode for a non-aqueous electrolyte secondary battery of the present invention indudes the steps of (a) generating a thermal plasma, (b) supplying a raw material of active material into the thermal plasma, and (c) depositing particles produced in the thermal plasma on a surface of a current collector to give an active material layer.

Here, the particles produced in the thermal plasma indude particles formed through the vaporization or decomposition of the raw material as well as ions or radicals produced as a result of the decomposition of a gas for generating the thermal plasma. While being recombined or reacting with gas, ions or radicals in the thermal plasma, the vaporized or decomposed raw material is deposited on the surface of the current collector.

When the production method of the present invention is compared with another film forming method such as sputtering, according to the production method of the present invention, the film growth rate (i.e., the increase in the film thickness per unit time) of the active material layer is considerably high, and the active material layer can be formed more rapidly by a factor of several tens. In the production method of the present invention, the film growth rate of the active material layer is 10⁻³ to 10⁻¹ µm/s; and in the general sputtering, the film growth rate of the active material layer is 10⁻⁵ to 10⁻⁴ µm/s.

The detailed reason why the film growth rate of the active material layer is increased in the production method of the present invention remains to be clarified, but is presumably as follows.
First, by using thermal plasma, a highly reactive field can be generated over a wide region. As such, for example, if a raw material is supplied more rapidly than in sputtering by a factor of several tens, the raw material is vaporized or decomposed sufficiently, to be synthesized into an active material. This presumably results in an improved film growth rate of the active material layer.

Secondly, the particles produced in the thermal plasma are cooled in a vicinity of the current collector, and the particles are partially bonded together, forming nano-sized clusters. Presumably because the particles produced in the thermal plasma have a large energy and readily adhere to the current collector, the film growth rate of the active material layer is improved. Further, presumably because the dusters are hard to be separated from the current collector, the adhesion of the active material layer is improved.

The thermal plasma is a plasma in such a state that the thermal energies of electrons, ions, and neutral particles are high. The temperatures of the electrons, ions, and neutral particles contained in the thermal plasma are all high, and the temperatures are almost the same. The temperatures of the electrons, ions, and neutral particles at a highest temperature portion of the thermal plasma are, for example, 10,000 to 20,000 K.

Examples of the method of generating a thermal plasma include, without any particular limitation, a method using DC arc electric discharge, a method using high-frequency electromagnetic field, and a method using microwaves, and other methods. Among these, a method using high-frequency electromagnetic field is preferable. The thermal plasma is preferably generated in an atmosphere having a pressure (e.g., 10⁴ to 10⁶ Pa) dose to the atmospheric pressure.

On the other hand, a low-temperature plasma is generated in a low pressure atmosphere (e.g.10¹ Pa or less). In the low-temperature plasma, only the temperature of electrons is high, and the temperatures of ions and neutral particles are low. The low-temperature plasma is used, for example, for sputtering and the like.

According to a conventional general production method of an electrode, first, an active material and a resin binder are mixed together with a liquid component to prepare a material mixture paste. Thereafter, the material mixture paste is applied onto a current collector and dried, followed by rolling. In contrast, according to the production method of the present invention, there is no need to use a binder and there is no need to perform rolling. In addition, the raw material of active material can be supplied in a powder state into the thermal plasma. As such, an electrode having a high energy density can be obtained with fewer steps.

Now referring to the drawings, one example of a film forming apparatus utilizing a high-frequency electromagnetic field is described.

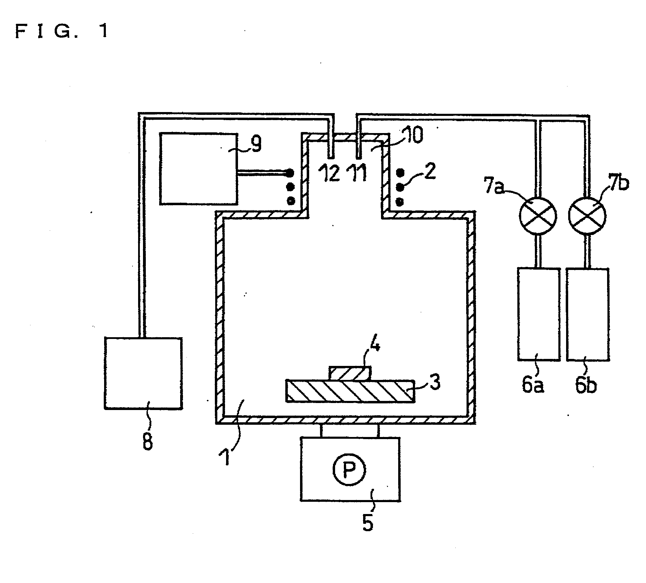

FIG 1 is a cross-sectional schematic representation of a film forming apparatus. The film forming apparatus indudes a chamber 1 for providing a space for film formation and a thermal plasma generation source. The thermal plasma generation source indudes a torch 10 for providing a space for generating a thermal plasma, and an induction coil 2 surrounding the torch 10. To the induction coil 2, a power source 9 is connected.

The chamber 1 may be provided, as needed, with an air exhaust pump 5, which may not be provided. When the air exhaust pump 5 is used to remove the residual air in the chamber 1 before generating a thermal plasma, the contamination of the active material can be suppressed. Using the air exhaust pump 5 allows easy control of the form of the plasma gas flow. Further, the conditions for film formation, for example, the pressure in the chamber 1 and the like can be easily controlled. The chamber 1 may also be provided with a filter (not shown) for collecting dust particles.

A stage 3 is placed vertically below the torch 10. The stage 3 may be made of any material without any particular limitation, but a material excellent in heat resistance is preferable, examples of which indude stainless steel. A current collector 4 is disposed on the stage 3. The stage 3 may be provided, as needed, with a cooling unit (not shown) for cooling the current collector.

One end of the torch 10 is open to the chamber 1. When a high-frequency voltage is used, the torch 10 is preferably made of a material having an excellent heat resistance and insulating property, preferable examples of which indude ceramics (e.g., quartz and silicon nitride). The inner diameter of the torch 10 is not particularly limited. By increasing the inner diameter of the torch, a larger reaction field is provided. As such, an efficient formation of an active material layer is made possible.

In the other end of the torch 10, a gas supply port 11 and a raw material supply port 12 are disposed. The gas supply port 11 is connected with gas supply sources 6a and 6b through valves 7a and 7b. The raw material supply port 12 is connected with a raw material supply source 8. By supplying gas to the torch 11 through the gas supply port 11, an efficient generation of thermal plasma is made possible.

In view of stabilizing the thermal plasma and controlling the gas flow in the thermal plasma, the number of the gas supply port 11 provided may be two or more. When two or more gas supply ports 11 are provided, the direction in which the gas is introduced is not particularly limited, and the gas may be introduced in the direction along the axis of the torch 10 or may be in the direction perpendicular to the axis of the torch 10. The ratio of an amount of gas introduced in the direction along the axis of the torch 10 to an amount of gas introduced in the direction perpendicular to the axis of the torch 10 is preferably 100:0 to 10:90. With the increase of the amount of gas introduced in the direction along the axis of the torch 10, the gas flow in the thermal plasma is narrowed, and the temperature in the center portion of the gas flow is elevated, and therefore, the raw material is readily vaporized or decomposed. In view of stabilizing the thermal plasma, it is preferable to control the amount of gas to be introduced using a mass flow controller (not shown).

Applying voltage to the induction coil 2 from the power source 9 generates a thermal plasma in the torch 10. The voltage applied may be a high-frequency voltage, or a DC voltage, or alternatively a combination of a high-frequency voltage and a DC voltage. When the high-frequency voltage is used, the frequency thereof is preferably 1000 Hz or more. The induction coil 2 may be made of any material without any particular limitation, and may be made of a metal with low resistivity such as copper.

While a thermal plasma is being generated, the temperatures of the induction coil 2 and the torch 10 become high. It is preferable, therefore, to provide a cooling unit (not shown) around the induction coil 2 and the torch 10. As the cooling unit, for example, a water cooling apparatus or the like may be used.

The steps (a) to (c) are described below.

### (1) Step (a)

In the step (a), a thermal plasma is generated. The thermal plasma is preferably generated in an atmosphere containing at least one gas selected from the group consisting of argon, helium, oxygen, hydrogen, and nitrogen. In view of generating the thermal plasma in a stable and efficient manner, the thermal plasma is more preferably generated in an atmosphere containing a diatomic molecule such as hydrogen. When a reactive gas such as oxygen, hydrogen, nitrogen, and organic gas is used in combination with an inert gas such noble gas, the reaction between the raw material and the reactive gas may be utilized to produce an active material.

When a high-frequency electromagnetic field is utilized, the thermal plasma is generated by applying a high frequency to the coil from an RF power source. Here, the frequency of the power source is preferably, for example, 1000 Hz or more, and, for example, 13.56 MHz. The utilization of high-frequency induction heating does not require the use of electrodes, thus causing no contamination of the active material due to the electrodes. As such, an electrode for a non-aqueous electrolyte secondary battery having excellent charge/discharge characteristics can be provided.

When the film forming apparatus as shown in FIG 1 is used, the jet velocity of the gas ejected from the gas supply port can be set to be slower than the jet velocity (several thousands m/s) when DC arc discharge is used to generate plasma, specifically to about several tens to hundreds m/s, and, for example, to 900 m/s or less. By doing this, the raw material is allowed to stay in the thermal plasma for a comparatively long period of time, and thus can be dissolved, evaporated or decomposed sufficiently in the thermal plasma. As such, an efficient synthesis of an active material and an efficient formation thereof into a film on the current collector are made possible.

The structure of the active material layer can be controlled by the temperature of the thermal plasma in a vicinity of the current collector. It is preferable therefore that information on a relationship between a temperature of the thermal plasma in a vicinity of the current collector and a structure of an active material layer be obtained in advance. By controlling the temperature of the thermal plasma in a vicinity of the current collector on the basis of the obtained information, an active material layer having a desired structure can be obtained.

The temperature of the thermal plasma in a vicinity of the current collector is preferably 500 to 1300°C, and more preferably lower than a melting point of the component material of the current collector, although being different depending on what the current collector is made of. When the temperature of the thermal plasma in a vicinity of the current collector is lower than 500°C, the active material does not sufficiently adhere to the current collector, and may be easily separated therefrom.
When the temperature of the thermal plasma in a vicinity of the current collector exceeds 1300°C, the current collector may be denatured or deformed.

The method of controlling the temperature of the thermal plasma in a vicinity of the current collector is not particularly limited, and for example, may be controlled by the distance between the torch and the current collector, the form of the gas flow in the thermal plasma, and the output power of the high-frequency voltage to be applied to the induction coil. The smaller the distance between the current collector and the torch, the higher the temperature of the thermal plasma in a vicinity of the current collector becomes; the larger the amount of gas flowing in the direction along the axis of the torch, the higher the temperature of the thermal plasma in a vicinity of the current collector becomes; and the more the output power of the high-frequency voltage to be applied to the induction coil is increased, the higher the temperature of the thermal plasma in a vicinity of the current collector becomes.

### (2) Step (b)

In the step (b), a raw material of active material is supplied into the thermal plasma. By doing this, particles serving a precursor of the active material are produced in the thermal plasma. When two or more raw materials are used, although each raw material may be separately supplied into the thermal plasma, it is preferable to mix these raw materials together sufficiently before being supplied into the thermal plasma.

The raw material to be supplied into the thermal plasma may be in a liquid state or in a powder state. However, supplying the raw material in a powder state is more simple and easier and advantageous in terms of production costs. In addition, raw materials in a powder state are comparatively inexpensive as compared to raw materials in a liquid state (e.g., alkoxide etc).

If the raw material is supplied in a liquid state into the thermal plasma, the removal of impurities such as the solvent or carbon may be required. In contrast, when the raw material is supplied in a powder state into the thermal plasma, since such impurities as above are not contained, an electrode for a non-aqueous electrolyte secondary battery having excellent electrochemical characteristics can be obtained.

When the raw material is supplied in a powder state into the thermal plasma, D50 (median diameter by volume) of the raw material is preferably less than 20 µm. If the median diameter of the raw material exceeds 20 µm, the raw material may not be vaporized or decomposed sufficiently in the thermal plasma, and therefore, an active material may be unlikely to be produced.

Although different depending on the volume of the apparatus, the temperature of the plasma, and other conditions, the supply rate of the raw material into the thermal plasma is preferably, for example, 0.0002 to 0.05 g/min per kilowatt of the output power of the high-frequency voltage to be applied to the induction coil. Controlling the supply rate of the raw material into the thermal plasma provides an active material layer including adequate gaps or pores extending from the surface thereof to the current collector, and changing stepwise the supply rate of the raw material into the thermal plasma during film formation provides, for example, an active material layer having a plurality of layers different in porosity.

When the supply rate of the raw material into the thermal plasma exceeds 0.05 g/min per kilowatt of the output power of the high-frequency voltage to be applied to the induction coil, the adhesion with the current collector may be reduced.

The detailed reason why the adhesion with the current collector is reduced remains to be clarified, but is presumably that, first, when the raw material is supplied at a high rate, the thermal plasma is deprived of a large amount of the melting heat which is required for melting the raw material. Consequently, the raw material is not sufficiently vaporized or decomposed in the thermal plasma, and therefore, is not synthesized into an active material and may be deposited in the form of the raw material itself on the current collector.

Secondly, when the raw material is supplied at a high rate into the thermal plasma, the particles collide with each other before adhering to the current collector, presumably forming particles of about several hundreds nm to about several µm in size. When the temperature of the thermal plasma in a vicinity of the current collector is low, the particles of about several hundreds nm to about several µm in size adhere onto the current collector with the particle size thereof being kept unchanged, and particles having a comparatively large size may be deposited and formed into a film. Such an active material layer has a comparatively high porosity, which may fail to have a sufficient adhesion.

When the supply rate of the raw material into the thermal plasma is 0.001 to 0.01 g/min per kilowatt of the output power of the high-frequency voltage to be applied to the induction coil, an active material layer having a dendritic structure is likely to be formed. The particles produced in the thermal plasma are rapidly cooled before being deposited on the current collector, forming dusters. Although the detailed reason why the dendritic structure is formed remains to be clarified, but is presumably that the dusters are deposited from the surface of the current collector toward the plasma being a heat source.

When the supply rate of the raw material into the thermal plasma is less than 0.001 g/min per kilowatt of the output power of the high-frequency voltage to be applied to the induction coil, the amount of energy of the thermal plasma to be lost as the dissolution heat of the raw material is very small. Consequently, the thermal plasma can dissolve, vaporize or decompose the raw material while retaining its high energy. The decomposed raw material travels while being irradiated with a high-energy thermal plasma to reach a vicinity of the surface of the current collector, and there synthesized into an active material, which then deposits on the surface of the current collector The porosity of the active material layer, therefore, tends to be comparatively small.

The structure of the active material layer can be controlled by the supply rate of the raw material into the thermal plasma. It is preferable therefore that information on a relationship between a supply rate of the raw material into the thermal plasma and a structure of an active material layer be obtained in advance. By controlling the supply rate of the raw material into the thermal plasma on the basis of the obtained information, an active material layer having a desired structure can be formed.

As the raw material of active material, various materials may be used. For example, (i) a raw material containing a transition metal compound; (ii) a raw material containing a transition metal compound and a lithium compound; (iii) a raw material containing a lithium-containing transition metal oxide; (iv) a raw material containing at least one selected from the group consisting of Si, Sn, and Pb; and the like may be used. The above materials (ii) and (iii) are suitable as a raw material of positive electrode active material; and the above material (iv) is suitable as a raw material of negative electrode active material.

Examples of the transition metal compound indude a nickel compound, a cobalt compound, a manganese compound, and an iron compound. These may be used alone or in combination of two or more. Examples of the nickel compound indude nickel oxide, nickel carbonate, nickel nitrate, nickel hydroxide, and nickel oxyhydroxide. Examples of the cobalt compound include cobalt oxide, cobalt carbonate, cobalt nitrate, and cobalt hydroxide. Examples of the manganese compound indude manganese oxide, and manganese carbonate. Examples of the iron compound indude iron oxide, and iron carbonate.

Examples of the lithium compound indude lithium oxide, lithium hydroxide, lithium carbonate, and lithium nitrate.
These may be used alone or in combination of two or more.

For example, in the case of forming an active material layer containing a lithium transition metal oxide, a lithium compound and a compound containing a transition metal are supplied as a raw material of active material into the thermal plasma. Although these compounds may be separately supplied into the thermal plasma, it is preferable to mix these compounds together sufficiently before being supplied into the thermal plasma.

Since lithium is easy to evaporate in thermal plasma, the mixing ratio of the lithium compound in the raw material is preferably larger than the stoichiometric ratio of the lithium in an active material to be formed.

Examples of the combination of materials are specifically listed below.
For forming an active material layer containing LiCoO₂, it is preferable to use a lithium compound and a cobalt compound as the raw material of active material.
For forming an active material layer containing LiNiₓC₁₋ₓO₂, it is preferable to use a lithium compound, a cobalt compound, and a nickel compound as the raw material of active material layer.
For forming an active material layer containing LiNiₓMn₁₋ₓO₂, it is preferable to use a lithium compound, a manganese compound, and a nickel compound as the raw material of active material layer.
For forming an active material layer containing LiNiₓFe₁₋ₓO₂, it is preferable to use a lithium compound, a nickel compound, and an iron compound as the raw material of active material layer.

It is possible to use a lithium-containing transition metal oxide (an active material itself) as the raw material.
The lithium-containing transition metal oxide supplied into the thermal plasma is dissolved, vaporized or decomposed, then synthesized again, and deposited on the current collector.

Examples of the lithium-containing transition metal oxide used as the raw material indude LiₓNi_{y}Co_{1-y-z}Al_{z}O₂, LiₓNi_{y}Mn_{1-y}O₂, LiₓNi_{y}Fe_{1-y}O₂, LiₓNi_{1/3}Mn_{1/3}Co_{1/3}O₂, LiₓMn₂O₄, LiNbO₃, LiₓFe_{y}Mn_{1-y}PO₄, and LiₓCoPO₄, where 0.8 ≤ x ≤ 1.5, 0 ≤ y ≤ 1, and 0 ≤ z ≤ 0.2. These may be used alone or in combination of two or more.

When these materials are used to form an active material layer by means of thermal plasma, a well-crystallized active material is obtained without the need of performing post-annealing which is required in sputtering and the like. As such, it is possible to produce at low cost an electrode having a high density and excellent charge/discharge characteristics for a non-aqueous electrolyte secondary battery.

Further, in the case of forming an active material layer containing SnO_{α}, SiO_{α}, and PbO_{α}, where 0 ≤ α a < 2, and the like, a raw material containing at least one selected from the group consisting of Si, Sn, and Pb is supplied as the raw material of active material into the thermal plasma. Examples of such a raw material indude SnO_{α}, SiO_{α}, and PbO_{α} (active material itself). These may be used alone or in combination of two or more.

Examples of the combination of materials are specifically listed below.
For forming an active material layer containing SiOₓ, Si and SiO may be used as the raw material of active material, which are mixed together such that Si:O =1:x in terms of stoichiometric ratio, and supplied into the thermal plasma.
For forming an active material layer containing PbOₓ, Pb and PbO may be used as the raw material of active material, which are mixed such that Pb:O =1:x in terms of stoichiometric ratio, and supplied into the thermal plasma.
For forming an active material layer containing SnOₓ, Sn and SnO may be used as the raw material of active material, which are mixed such that Sn:O =1:x in terms of stoichiometric ratio, and supplied into the thermal plasma.
Other preferable raw materials are, for example, Nb₂O₅, V₂O₅, Li_{4/3}Ti_{5/3}O₄, MoO₂, and the like.

In the case of forming an active material layer containing an oxide, a thermal plasma may be generated in an atmosphere containing at least oxygen. For example, by generating a thermal plasma in an atmosphere containing oxygen and argon, an efficient formation of an active material layer containing an oxide is made possible.

### (3) Step (c)

The particles produced in the thermal plasma travel in a direction substantially normal to the surface of the current collector and are deposited on the current collector, forming an active material layer. As such, the process of forming an active material layer is simplified. The conventional production method of an electrode, however, requires the steps of preparing an active material, forming the prepared active material into a paste, and then applying the paste onto the current collector.

The production method of the present invention provides an active material layer having a structure different from that of an active material layer obtained by the paste applying method. The active material layer formed by means of thermal plasma tends to have gaps or pores formed from the surface thereof to the current collector. It is considered, therefore, that unlike an active material layer formed by means of sputtering or CVD, the active material layer provided by the method of the present invention does not have a closely packed structure extending from the surface thereof to the current collector. As such, when the thickness reaches a necessary thickness for an active material layer in a non-aqueous electrolyte secondary battery (e.g., 10 µm or more), excellent charge/discharge characteristics are obtained.

In view of protecting the current collector from the thermal plasma of high temperature, and suppressing the denaturation or deformation thereof, it is preferable to form a first layer having a comparatively small porosity on the surface of the current collector, and then form a second layer thereon having a porosity larger than that of the first layer. It is preferable to form an active material layer comprising two or more layers by performing the step of forming an active material layer in two or more separate steps.

For example, by setting the temperature of the thermal plasma in a vicinity of the current collector to be comparatively low (e.g., 500 to 1000°C) and decreasing the supply rate of the raw material into the thermal plasma, it is possible to provide a first layer having a comparatively small porosity, while suppressing the denaturation or deformation of the current collector. When the thickness of the first layer is, for example, 0.01 to 10 µm, the current collector is favorably protected.

Thereafter, by selecting the conditions as appropriate, a second layer having a desired structure is formed. For example, by setting the temperature of the thermal plasma in a vicinity of the current collector to be comparatively high (e.g., 500 to 1300°C) and increasing the supply rate of the raw material into the thermal plasma, it is possible to increase the film growth rate of the active material layer as a whole. Here, the first layer having a comparatively dosely-packed structure functions to suppress the denaturation or deformation of the current collector.

Controlling both the supply rate of the raw material into the thermal plasma and the temperature of the thermal plasma in a vicinity of the current collector can provide an electrode for a non-aqueous electrolyte secondary battery having excellent electrochemical characteristics at a higher film growth rate.

Now referring to the drawings, one example of a non-aqueous electrolyte secondary battery including, as a positive electrode or negative electrode, the electrode obtained according to the above-described production method is described.

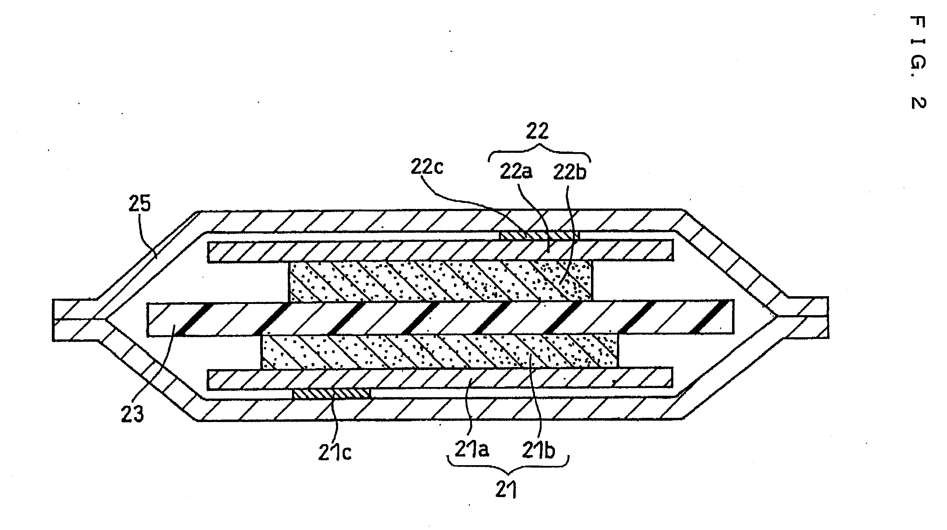

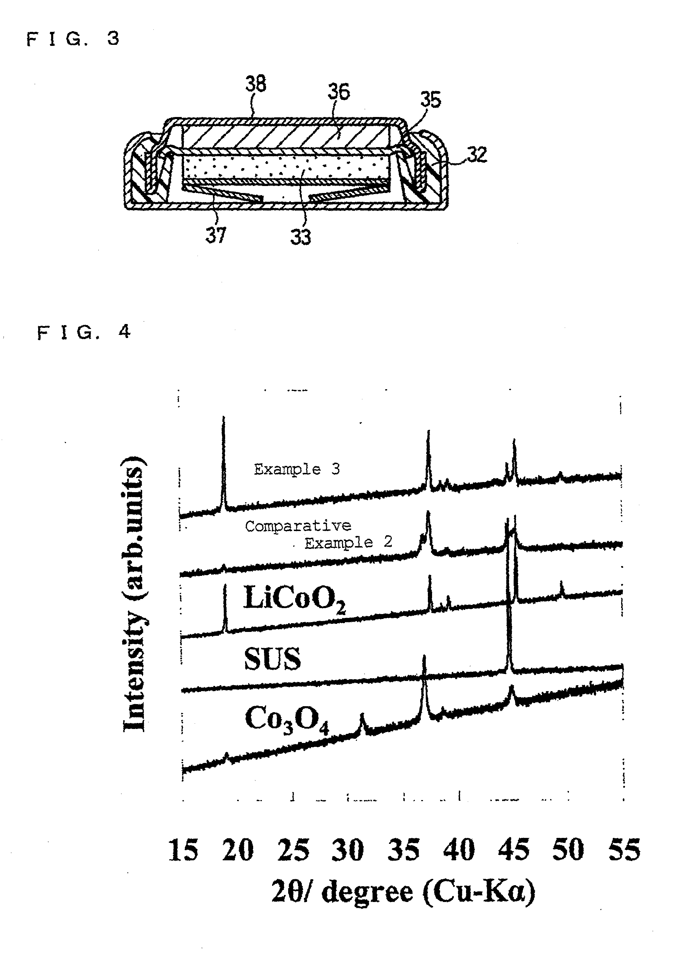

FIG 2 is a schematic cross-sectional view of a laminated battery; and FIG 3 is a schematic cross-sectional view of a coin battery.

The laminated battery of FIG 2 indudes an electrode assembly, a non-aqueous electrolyte (not shown), and a packaging case 25 for housing these. The electrode assembly indudes a negative electrode 21, a positive electrode 22 facing the negative electrode 21 and being capable of absorbing lithium ions during discharge, and a porous separator 23 interposed therebetween. The separator 23 is impregnated with the non-aqueous electrolyte. The opening of the packaging case 25 is sealed with a resin material.

The positive electrode 22 is composed of a positive electrode current collector 22a and a positive electrode active material layer 22b carried on the positive electrode current collector 22a. The negative electrode 21 is composed of a negative electrode current collector 21 a and a negative electrode active material layer 21 b. To the negative electrode current collector 21 a and the positive electrode current collector 22a, one end of a negative electrode lead 21 c and one end of a positive electrode lead 22c are connected, respectively. The other end of the positive electrode lead 22c and the other end of the negative electrode lead 21 c are guided outside the packaging case 25.

The coin battery of FIG 3 indudes a positive electrode 33, a negative electrode 36, a separator 35 interposed therebetween, and a non-aqueous electrolyte (not shown). To the positive electrode 33, a leaf spring 37 is connected. The leaf spring 37 has a function of adjusting the distance between the positive electrode 33 and the negative electrode 36. The separator 35 is impregnated with the non-aqueous electrolyte. A gasket 32 insulates a case 31 for housing the positive electrode 33, the negative electrode 36, and the separator 35 from a sealing plate 38.

Both the positive electrode and the negative electrode may be the electrode obtained according to the above-described production method, or only one of the electrodes may be the electrode obtained according to the above-described production method. In the latter case, the other one of the electrodes may be an electrode produced by the conventional method. For example, an electrode formed using a material mixture containing an active material and an optional component may be used.
The configuration of the conventional electrode is described below.

For the positive electrode active material, a lithium-containing transition metal oxide such as LiCoO₂, LiNiO₂, and LiMn₂O₄; an olivine-type lithium phosphate represented by the general formula LiMPO₄, where M is at least one selected from the group consisting of V, Fe, Ni, and Mn; a lithium fluorophosphate represented by the general formula Li₂MPO₄F, where M is at least one selected from the group consisting of V, Fe, Ni, and Mn; or the like is used. Part of component elements in these lithium-containing compounds may be substituted by a different element.

For the negative electrode active material, a carbon material, a metal, an alloy, a metal oxide, a metal nitride, or the like is used. Preferable examples of the carbon material indude natural graphite and artificial graphite. Preferable examples of the metal or alloy indude elementary lithium, a lithium alloy, elementary silicon, a silicon alloy, elementary tin, and a tin alloy. Preferable examples of the metal oxide indude SiOₓ, where 0 < x < 2, and preferably, 0.1 ≤ x ≤ 1.2.

The active material layer comprising a material mixture may include, as needed, a conductive material and a binder in addition to the active material. For the conductive material, graphites such as natural graphite and artificial graphite; carbon blacks such as acetylene black, Ketjen black, channel black, furnace black, lamp black, and thermal black; conductive fibers such as carbon fiber and metal fiber; fluorocarbon; metal powders such as aluminum; conductive whiskers such as zinc oxide and potassium titanate; conductive metal oxides such as titanium oxide; organic conductive materials such as phenylene derivatives; or the like may be used.

For the binder, for example, PVDF, polytetrafluoroethylene, polyethylene, polypropylene, aramid resin, polyamide, polyimide, polyamide-imide, polyacrylonitrile, polyacrylic add, polymethyl acrylate, polyethyl acrylate, polyhexyl acrylate, polymethacrylic add, polymethyl methacrylate, polyethyl methacrylate, polyhexyl methacrylate, polyvinyl acetate, polvinylpyrrolidone, polyether, polyether sulfone, hexafluoropolypropylene, styrene-butadiene rubber, carboxymethyl cellulose, or the like may be used. Further, a copolymer of at least two materials selected from the group consisting of tetrafluoroethylene, hexafluoroethylene, hexafluoropropylene, perfluoroalkylvinylether, vinylidene fluoride, chlorotrifluoroethylene, ethylene, propylene, pentafluoropropylene, fluoromethylvinylether, acrylic add, and hexadiene may be used. Furthermore, two or more selected from these may be used in combination.

The current collector carrying the active material layer is not particularly limited, and may be, for example, a conductive material generally used in an electrochemical device.
For the positive electrode current collector, a current collector of AI, Ti, stainless steel (SUS), Au, Pt, or the like is preferably used. These current collectors are preferable because even when Li deintercalation reaction proceeds until the voltage reaches about 3.5 to 4.5 V (vs. Li/Li⁺), the amount of metal leached out of the current collector is comparatively small.

For the negative electrode current collector, a current collector of Cu, Ni, SUS, or the like is preferably used. These current collectors are preferable because even when Li intercalation reaction proceeds until the voltage reaches about 0 to 3.5 V (vs. Li/Li⁺), the amount of metal leached out of the current collector is comparatively small.

For the separator, for example, a nonwoven fabric or microporous film made of polyethylene, polypropylene, aramid resin, amide-imide, polyphenylene sulfide, polyimide, or the like may be used. The nonwoven fabric or microporous film may be formed of a single layer or have a multi layer structure. In the interior or surface of the separator, a heat resistant filler such as alumina, magnesia, silica, titania may be included.

The non-aqueous electrolyte indudes a non-aqueous solvent and a solute dissolved in the non-aqueous solvent. The solute is not particularly limited, and may be any solute selected as appropriate according to the redox potential of the active material and other conditions. Preferable examples of the solute indude LiPF₆, LiBF_{4,} LiCIO₄, LiAlCl₄, LiSbF₆, LiSCN, LiCF₃SO₃, LiOCOCF₃, LiAsF₆, LiB₁₀Cl₁₀, lithium lower aliphatic carboxylate, LiF, LiCI, LiBr, LiI, chloroborane lithium, boric acid salts such as lithium bis(1,2-benzendioleate(2-)-O,O') borate, lithium bis(2,3-naphthalenedioleate(2-)-O,O') borate, lithium bis(2,2'-biphenyldioleate(2-)-O,O') borate, and lithium bis(5-fluoro-2-oleate-1-benzenesulfonate-O,O') borate, LiN(CF₃SO₂)₂, LiN(CF₃SO₂)(C₄F₉SO₂), LiN(C₂FsSO₂)₂, and lithium tetraphenylborate.

The non-aqueous solvent is also not particularly limited. For example, ethylene carbonate (EC), propylene carbonate, butylene carbonate, vinylene carbonate, dimethyl carbonate (DMC), diethyl carbonate, ethyl methyl carbonate (EMC), dipropyl carbonate, methyl formate, methyl acetate, methyl propionate, ethyl propanoate, dimethoxymethane, γ-butyrolactone, γ-valerolactone, 1,2-diethoxy ethane, 1,2-dimethoxyethane, ethoxymethoxyethane, trimethoxymethane, tetrahydrofuran, a tetrahydrofuran derivative such as 2-methyltetrahydrofuran, dimethylsulfoxide, 1,3-dioxolane, a dioxolane derivative such as 4-methyl-1,3-dioxolane, formamide, acetamide, dimethylformamide, acetonitrile, propylnitrile, nitromethane, ethyl monoglyme, phosphoric add triester, acetic acid ester, propionic add ester, sulfolane, 3-methylsulfolane, 1,3-dimethyl-2-imidazolidinone, 3-methyl-2-oxazolidinone, a propylene carbonate derivative, ethyl ether, diethyl ether, 1,3-propanesultone, anisole, fluorobenzene, and the like may be used. These may be used alone or in combination of two or more.

The non-aqueous electrolyte may include an additive. The additive is not particular limited, and may be, for example, vinylene carbonate, cydohexylbenzene, biphenyl, diphenyl ether, vinylethylene carbonate, divinylethylene carbonate, phenylethylene carbonate, diallyl carbonate, fluoroethylene carbonate, catechol carbonate, vinyl acetate, ethylene sulfite, propane sultone, trifluoropropylene carbonate, dibenzofuran, 2,4-difluoro anisole, o-terphenyl, m-terphenyl, and the like.

The non-aqueous electrolyte may be a solid electrolyte containing a polymer material, or a gelled electrolyte containing a non-aqueous solvent. For the polymer material, polyethylene oxide, polypropylene oxide, polyphosphazene, polyaziridine, polyethylene sulfide, polyvinyl alcohol, polyvinylidene fluoride, or polyhexafluoropropylene may be used.
Further, an inorganic material such as a lithium nitride, a lithium halide, a lithium oxyacid salt, Li₄SiO₄, Li₄SiO₄-LiI-LiOH, Li₃PO₄-Li₄SiO₄, Li₂SiS₃, Li₃PO₄-Li₂S-SiS₂, and a phosphorus sulfide compound may be used as the solid electrolyte.

### Examples

### <<Example 1>>

### (1) Production of negative electrode

### (i) Step (a)

For the film forming apparatus, a high frequency induction thermal plasma generator (TP-12010) available from JEOL (Nihon Denshi Kabushiki Kaisha) provided with a chamber having an interior volume of 19,625 cm³ and a thermal plasma generation source was used. For the thermal plasma generation source, a torch comprising a 042 cm silicon nitride tube and a copper induction coil surrounding the torch were used.

The stage was placed at a position 250 mm below the lower end of the torch in the chamber. On the stage, a current collector made of copper foil (thickness: 30 µm) was placed. Thereafter, the air in the chamber was replaced with argon gas.

Subsequently, argon gas was introduced into the chamber at a flow rate of 50 Umin, and further, hydrogen gas was introduced thereinto at a flow rate of 10 L/min. The pressure in the chamber was adjusted using an exhaust pump to be constant at 26 kPa. In such a state, a high frequency voltage of 42 kW at frequency 3.5 MHz was applied to the induction coil to generate a thermal plasma.

### (ii) Step (b)

From a raw material supply source, a raw material was supplied into the torch. For the raw material, a mixture of Si powder having a particle size (D50) of 5 µm and SiO powder having a particle size (D50) of 5 µm mixed together such that Si:O = 1:0.25 in terms of stoichiometric ratio was used. The supply rate of the raw material into the thermal plasma was 0.07 g/min. The supplied raw material was dissolved, vaporized, and decomposed in the thermal plasma, whereby particles to be used as an active material precursor was produced.

### (iii) Step (c)

The temperature of the thermal plasma in a vicinity of the current collector at this time was considered to be 600 to 700°C. The particles produced in the thermal plasma traveled in a direction substantially normal to the surface of the current collector and were deposited on the current collector. With the deposition time being set for 30 minutes, an active material layer was formed. The thickness of the active material layer thus obtained was 10 µm.

An element analysis of the cross section of the active material layer was performed with respect to Si and O using EPMA by linear distribution measurement. The result confirmed that the element ratio in the film was Si:O =1:0.25, and Si and O were almost evenly distributed in the active material layer. The presence of gaps or small pores was observed from the surface of the active material layer to the current collector.

On the surface of a negative electrode, metallic Li was vapor-deposited using a vacuum vapor deposition method. The thickness of a metallic Li layer to be formed was set to 11 µm. The degree of vacuum in the vapor deposition of Li was set to 0.04 Pa; the vapor deposition temperature was set to 550°C, and the vapor deposition rate was set to 30 nm/s. A current collector exposed portion was provided in an area where the negative electrode does not face the positive electrode, and a negative electrode lead made of copper was welded thereto, whereby a finished negative electrode was obtained.

### (2) Production of positive electrode

First, 93 parts by weight of LiCoO₂ powder serving as the positive electrode active material and 4 parts by weight of acetylene black serving as the conductive material were mixed together. To the resultant mixture, an N-methyl-2-pyrrolidone (NMP) solution of polyvinylidene fluoride (PVDF) (product No. #1320, available from by Kureha Chemical Industry Co., Ltd.) serving as the binder was added such that the weight of the PVDF was 3 parts by weight, and an appropriate amount of NMP was further added, to prepare a positive electrode material mixture paste.

The positive electrode material mixture paste was applied onto one surface of a positive electrode current collector using a doctor blade method, and the applied film was dried at 85°C for 120 minutes. Thereafter, the applied film was rolled so that its density reached 3.5 g/cm³ and its thickness reached 160 µm, to form a positive electrode active material layer, followed by cutting. A current collector exposed portion was provided in an area where a positive electrode does not face the negative electrode, and a positive electrode lead made of aluminum was welded thereto, whereby a finished positive electrode was obtained. For the positive electrode current collector, a 15-µm-thick aluminum foil was used.

### (3) Preparation of non-aqueous electrolyte

LiPF₆ serving as the solute was dissolved in a non-aqueous solvent at a concentration of 1.25 mol/L, to prepare a non-aqueous electrolyte. For the non-aqueous solvent, a mixed solution of ethylene carbonate and diethyl carbonate in a weight ratio of 1:3 was used.

### (4) Fabrication of Battery

A laminated battery as shown in FIG 2 was fabricated.

The negative electrode 21 and the positive electrode 22 were laminated with the separator 23 interposed therebetween, to form an electrode assembly 24 of 40 mm × 30mm square. For the separator 23, a 25-µm-thick polypropylene microporous film was used. The electrode assembly 24 was housed in the packaging case 25, and impregnated with the non-aqueous electrolyte. For the packaging case 25, a case made of a laminate sheet including aluminum foil was used. Thereafter, the opening was sealed to finish the battery. The design capacity was set to 40 mAh.

### <<Example 2>>

### (1) Production of positive electrode

### (i) Step (a)

For the film forming apparatus, the same high frequency induction thermal plasma generator as used in Example 1 was used. The stage was placed at a position 345 mm below the lower end of the torch in the chamber. On the stage, a current collector made of SUS sheet (thickness: 0.1 mm) was placed.

Argon gas was introduced into the chamber at a flow rate of 50 Umin, and oxygen gas was introduced thereinto at a flow rate of 30 Umin. The pressure in the chamber was adjusted to 18 kPa. A high frequency voltage of 42 kW at frequency 3.5 MHz was applied to the induction coil to generate a thermal plasma.

### (ii) Step (b)

For the raw material, LiCoO₂ powder having a particle size (D50) of 8.5 µm was used. Argon gas and oxygen gas were allowed to flow though a single flow channel at a flow rate of 50 L/min and 30 L/min, respectively, and the mixed gas of these was introduced into the chamber such that the ratio of an amount of the gas introduced in the direction along the axis of the torch to an amount of the gas introduced in the direction perpendicular to the axis of the torch (hereinafter referred to as the "axis direction : perpendicular direction") was set to 50:30. The supply rate of the raw material into the thermal plasma was set to 0.05 g/min (Condition 1).

Thereafter, the gas was introduced into the chamber with the gas flow amount ratio of (axis direction): (perpendicular direction) being set to 45:35. The supply rate of the raw material into the thermal plasma was set to 0.08 g/min

### (Condition 2).

### (iii) Step (c)

The temperature of the thermal plasma in a vicinity of the current collector at this time was considered to be 600 to 700°C. The particles produced in the thermal plasma traveled in a direction substantially normal to the surface of the current collector and were deposited on the current collector. Deposition of active material was performed under Condition 1 for 5 minutes to form a first layer having a thickness of 0.5 µm. Subsequently, deposition of active material was performed under Condition 2 for 20 minutes to form a second layer on the first layer. The thickness of the active material layer thus obtained (the total thickness of the first layer and the second layer) was 30 µm.
The result of ICP analysis on the active material layer confirmed that the element ratio in the active material layer was Li:Co = 0.75:1.

### (2) Preparation of non-aqueous electrolyte

LiPF₆ serving as the solute was dissolved in a non-aqueous solvent at a concentration of 1.25 mol/L, to prepare a non-aqueous electrolyte. For the non-aqueous solvent, a mixed solution of ethylene carbonate and ethyl methyl carbonate in a weight ratio of 1:3 was used.

### (3) Fabrication of Battery

A coin battery as shown in FIG 3 was fabricated.
Onto the inner surface of the sealing plate 38, a 0.3-mm-thick lithium foil was attached as the negative electrode 36. The separator 35 was disposed thereon. The positive electrode was disposed on the separator 35 such that the positive electrode active material layer faced the separator. The leaf spring 37 was disposed on the positive electrode. The non-aqueous electrolyte was poured into the sealing plate until it is filled, and then the case 31 was fitted with the sealing plate with the gasket 32 interposed therebetween, to finish a coin battery.

### <<Example 3>>

### (i) Step (a)

For the film forming apparatus, the same high frequency induction thermal plasma generator as used in Example 2 was used. The stage was placed at a position 345 mm below the lower end of the torch in the chamber. On the stage, a current collector made of SUS (430) sheet (thickness: 0.1 mm) was placed.
A thermal plasma was generated in the same manner as in Example 2.

### (ii) Step (b)

For the raw material, a mixture of Li₂O and Co₃O₄ was used. Li₂O had been pulverized to 30 µm or smaller. D50 of Co₃O₄ was 5 µm. Li₂O and Co₃O₄ had been mixed such that Li:Co =1.5:1 in terms of stoichiometric ratio.
The same mixed gas as used in Example 2 was introduced into the chamber with the gas flow amount ratio of (axis direction) : (perpendicular direction) being set to 30:50. The supply rate of the raw material into the thermal plasma was set to 0.035 g/min. Except the above, the conditions were the same as those in Example 2 (Condition 1).

Subsequently, the gas was introduced into the chamber with the gas flow amount ratio of (axis direction) : (perpendicular direction) being set to 35:45. The supply rate of the raw material into the thermal plasma was set to 0.11 g/min. Except the above, the conditions were the same as those in Example 2 (Condition 2).

### (iii) Step (c)

The temperature of the thermal plasma in a vicinity of the current collector at this time was considered to be 600 to 700°C. The particles produced in the thermal plasma traveled in a direction substantially normal to the surface of the current collector and were deposited on the current collector. Deposition of active material was performed under Condition 1 for 5 minutes to form a first layer. Subsequently, deposition of active material was performed under Condition 2 for 5 minutes to form a second layer on the first layer. The total thickness of the active material layer thus obtained was 4.3 µm.
The result of ICP analysis on the active material layer confirmed that the element ratio in the active material layer was Li:Co =1.2:1.
A coin battery was fabricated in the same manner as in Example 2 except that the above electrode was used as the positive electrode.

### <<Comparative Example 1>>

A current collector made of copper foil (thickness: 30 µm) was placed on the stage to form an active material layer on the copper foil using a magnetron sputtering apparatus. For the target, a mixture of Si powder and SiO powder mixed such that Si:O =1:0.25 in terms of stoichiometric ratio was used. The distance between the current collector on the stage and the target was set to 4 cm.

The degree of vacuum in the chamber was adjusted to 5 × 10⁻² Pa using a rotary pump and a diffusion pump. Thereafter, argon gas was introduced into the chamber at a flow rate of 10 × 10⁻³ Umin, so that the degree of vacuum in the chamber was adjusted to 1 Pa. A high frequency voltage of 80 W at frequency 13.56 MHz was applied to the target to generate plasma. With the temperature of the stage being set at 200°C and the deposition time of active material being set for 16 hours, an active material layer was formed. The thickness of the active material layer thus obtained was 8 µm.

An element analysis of the cross section of the active material layer was performed with respect to Si and O using EPMA by linear distribution measurement. The result confirmed that the element ratio in the active material layer was Si:O = 1:0.30, and Si and O were almost evenly distributed in the active material layer. Thereafter, on the surface of a negative electrode, metallic Li was vapor-deposited using a vacuum vapor deposition method. The thickness of a metallic Li layer to be formed was set to 11 µm. A battery was fabricated in the same manner as in Example 1 except the above.

### <<Comparative Example 2>>

A current collector made of SUS (430) sheet (thickness: 0.1 mm) was placed on the stage to form an active material layer on the current collector using a magnetron sputtering apparatus. For the target, a mixture of Li₂O powder and Co₃O₄ powder mixed such that Li:Co =1.5:1 in terms of stoichiometric ratio was used. The diameter of the target was set to 3 inches. The distance between the current collector on the stage and the target was set to 3.5 cm.

The degree of vacuum in the chamber was adjusted to 5 × 10⁻² Pa using a rotary pump and a diffusion pump.
Thereafter, argon gas was introduced into the chamber at a flow rate of 8 × 10⁻² Umin and oxygen gas was introduced thereinto at a flow rate of 2 × 10⁻² Umin, so that the degree of vacuum in the chamber was adjusted to 1 Pa. A high frequency voltage of 80 W at frequency 13.56 MHz was applied to the target to generate plasma. With the temperature in a vicinity of the current collector being set at 25°C and the deposition time of active material being set for 10 hours, an active material layer was formed. The thickness of the active material layer thus obtained was 5 µm.

The result of ICP analysis on the active material layer confirmed that the element ratio in the active material layer was Li:Co = 0.95:1. A battery was fabricated in the same manner as in Example 2 except that the electrode thus obtained was used as the positive electrode.

The batteries of Examples 1-3 and Comparative Examples 1-2 were subjected to charge and discharge. The charge and discharge were performed at a voltage ranging from 3.0 to 4.1 V versus Li/Li⁺, to measure an initial discharge capacity. The temperature condition was 20°C. The conditions for film formation and the results are shown in Table 1.

**[Table 1]**

| | Film forming method | High frequency Output (W)/ Frequency (MHz) | Raw material | Supply rate of raw material (g/min) Condition 1/ Condition 2 | Initial discharge capacity | Initial discharge capacity |
|---|---|---|---|---|---|---|
| | | | | | (mAh) | (mAh/g) |
| Ex. 1 | Thermal plasma | 4200/3.5 | Si, SiO | 0.07/- | 19 | - |
| Ex. 2 | Thermal plasma | 4200/3.5 | LiCoO₂ | 0.05/0.08 | - | 118 |
| Ex. 3 | Thermal plasma | 4200/3.5 | Li₂O, Co₃O₄ | 0.035/0.11 | - | 150 |
| Com. Ex. 1 | Sputtering | 80/13.56 | Si, SiO | - | 15 | - |
| Com. Ex. 2 | Sputtering | 80/13.56 | Li₂O, Co₃O₄ | - | - | 30 |

The film growth rate of the active material layer in Example 1 was considerably higher (about 100 times higher) than the film growth rate of the active material layer by sputtering in Comparative Example 1. From Table 1, the discharge capacity of battery of Comparative Example 1 is smaller than that of Example 1. Further, the active material layer of Comparative Example 1 had wrinkles.

Although the discharge capacity of the battery of Example 2 was 118 mAh/g, which was smaller than the theoretical capacity 160 mAh/g, it was confirmed that the battery operated charge and discharge. The discharge capacity was slightly reduced presumably because Li was partially evaporated in the thermal plasma, causing the Li/Co ratio to be as comparatively small as 0.75.

On comparison between Example 3 and Comparative Example 2 including the active material layers having almost the same uniform thickness, the deposition time in Example 2 was for 5 minutes, while the deposition time in Comparative Example 2 was for 10 hours. This indicates that the film growth rate of the active material layer when using thermal plasma was considerably higher (about 120 times higher) than that when using sputtering.

FIG 4 is a plot of X-ray diffraction patterns of positive electrode active material layers of Example 3 and Comparative Example 2. In the positive electrode active material layer of Example 3, a main peak corresponding to that of LiCO₂ having an *R-3m* crystal structure was observed. This indicates that LiCoO₂ to be used an active material has been synthesized and formed into a film. On the other hand, in the active material layer of Comparative Example 2, although a peak derived from LiCoO₂ was observed as a peak having a broad half-width, a peak derived from Co₃O₄ used as the raw material was also observed. This can be construed as follows: according to the sputtering using a low-temperature plasma (Comparative Example 2), the synthesis of LiCoO₂ was insufficient, and therefore, the crystallinity of LiCoO₂ was low, resulted in a reduced discharge capacity.

### <<Example 4>>

### (i) Step (a)

For the film forming apparatus, the same high frequency induction thermal plasma generator as used in Example 3 was used. The stage was placed at a position 335 mm below the lower end of the torch in the chamber. On the stage, the same current collector as used in Example 3 was placed. The same raw material and current collector as used in Example 3 were used.
The air in the chamber was replaced with argon gas. Subsequently, argon gas was introduced into the chamber at a flow rate of 50 Umin, and oxygen gas was introduced thereinto at a flow rate of 30 Umin. The pressure in the chamber 1 was adjusted to 18 kPa. A high frequency voltage of 42 kW at frequency 3.5 MHz was applied to the induction coil to generate a thermal plasma.

### (ii) Step (b)

The same material as used in Example 3 was used. The gas was introduced into the chamber with the gas flow amount ratio of (axis direcfion): (perpendicular direction) being set to 20:60. The conditions were the same as those in Example 3 except that the supply rate of the raw material into the thermal plasma was set to 0.065 g/min (Condition 1).

Subsequently, the gas was introduced into the chamber with the gas flow amount ratio of (axis direction): (perpendicular direction) being set to 30:50. The conditions were the same as those in Example 3 except that the supply rate of the raw material into the thermal plasma was set to 0.08 g/min (Condition 2).

### (iii) Step (c)

The temperature of the thermal plasma in a vicinity of the current collector at this time was considered to be 600 to 700°C. The particles produced in the thermal plasma traveled in a direction substantially normal to the surface of the current collector and were deposited on the current collector. Deposition of active material was performed under Condition 1 for 5 minutes to form a first layer having a thickness of 0.5 µm. Subsequently, deposition of active material was performed under Condition 2 for 5 minutes to form a second layer on the first layer. The total thickness of the active material layer thus obtained was about 3.5 µm.
The result of ICP analysis on the active material layer confirmed that the element ratio in the active material layer was Li:Co =1.2:1.

### <<Example 5>>

### (i) Step (a)

A thermal plasma was generated in the same manner as in Example 4.

### (ii) Step (b)

The same raw material as used in Example 3 was used. The gas was introduced into the chamber with the gas flow amount ratio of (axis direction) : (perpendicular direction) being set to 30:50. The supply rate of the raw material into the thermal plasma was set to 0.035 g/min. Under such conditions, particles were produced in the thermal plasma.

The temperature of the thermal plasma in a vicinity of the current collector at this time was considered to be 600 to 700°C. The particles produced in the thermal plasma traveled in a direction substantially normal to the surface of the current collector and were deposited on the current collector. With the deposition time of active material being set for 10 minutes, an active material layer was formed. The thickness of the active material layer thus obtained was 1 µm.
The result of ICP analysis on the active material layer confirmed that the element ratio in the active material layer was U:Co =1.2:1.

### «Comparative Example 3»

An electrode was produced in the same manner as in Comparative Example 2 except that the high frequency voltage to be applied to the target was a high frequency voltage of 180 W at frequency 13.56 MHz, and a battery was fabricated in the same manner as in Comparative Example 2.

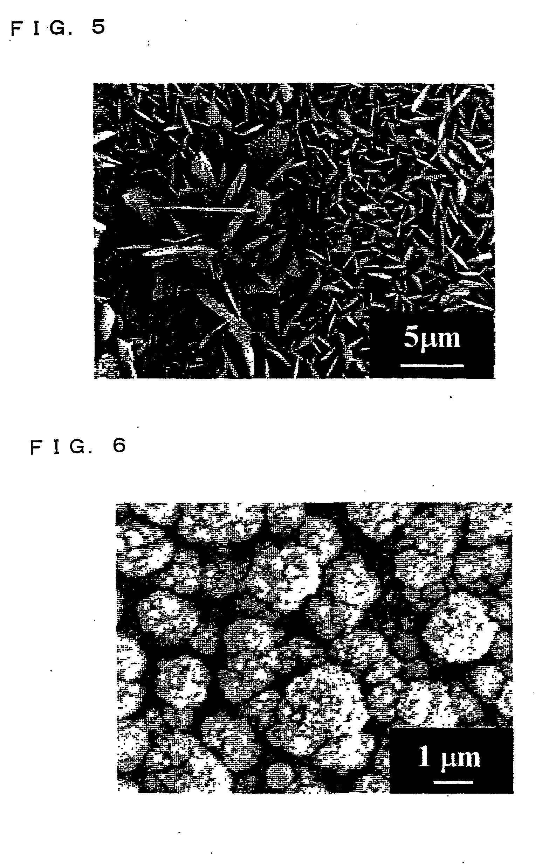

The conditions for film formation and the results are shown in Table 2. Further, the electron micrographs on the surfaces of the active material layers obtained in Examples 3 to 5 and Comparative Examples 2 to 3 are shown in FIGS. 5 to 9.

**[Table 2]**

| | Film forming method | High frequency Output (W)/ Frequency (MHz) | Raw material | Supply rate of raw material (g/min) Condition 1/ Condition 2 |
|---|---|---|---|---|
| Ex. 4 | Thermal plasma | 4200/3.5 | Li₂O, Co₃O₄ | 0.065/0.08 |
| Ex. 5 | Thermal plasma | 4200/3.5 | Li₂O, Co₃O₄ | 0.035/- |
| Com. Ex. 3 | Sputtering | 180/13.56 | Li₂O, Co₃O₄ | - |

From FIG 5, the active material layer of Example 3 contained particles having a size of about several µm.
From FIG 6, in Example 4, an active material layer containing dendritic particles was formed. The larger the distance between the torch and the current collector was, the lower the temperature of the thermal plasma in a vicinity of the current collector was. Further, the higher the supply rate of the raw material into the thermal plasma was, the more likely the active material layer had a structure composed of deposited powder. Based on the foregoing, it is understood that controlling the temperature of the thermal plasma in a vicinity of the current collector and the supply rate of the raw material into the thermal plasma enables the control of the structure of the active material.

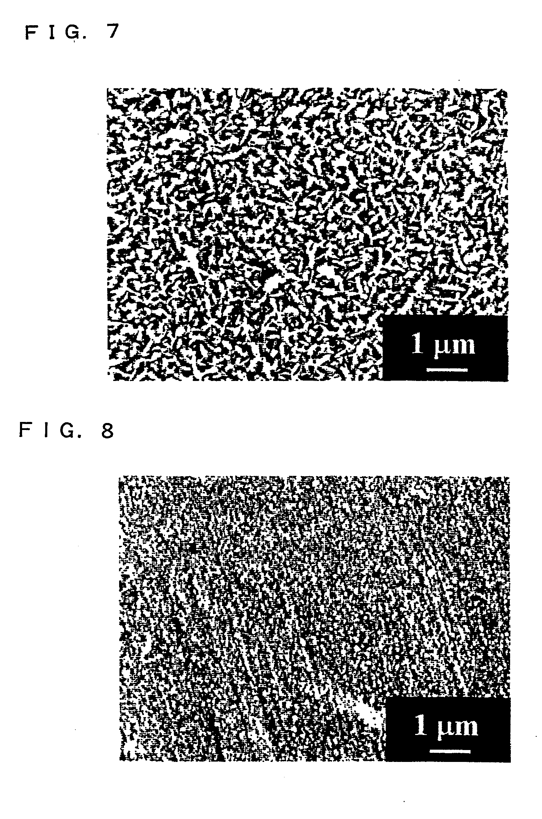

From FIG 7, in Example 5 in which the raw material was supplied into the thermal plasma at a lower rate than Example 4, an active material layer having a comparatively small porosity was formed. Based on the foregoing, it is understood that controlling the supply rate of the raw material into the thermal plasma enables the control of the structure of the active material.

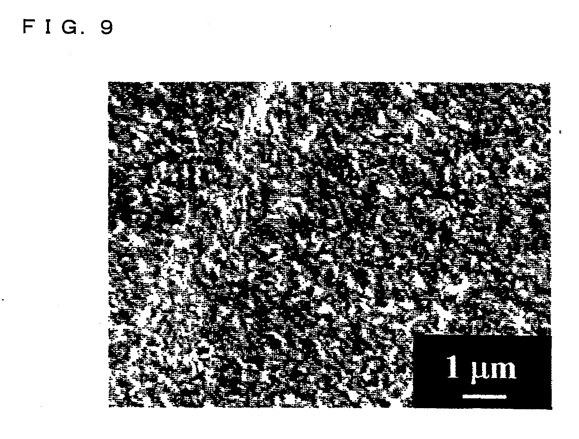

In Comparative Example 2 and Comparative Example 3, the high frequency powers were set to 80 W and 180 W, respectively. With the increase of the high frequency power, the energy of the plasma to be generated is raised. Further, the amount of atoms to be sputtered is increased, and for this reason, the supply rate of the raw material into the thermal plasma is considered to be increased. However, from FIGS. 8 and 9, almost no change was observed in the structure of the active material layer.

Based on the foregoing, it is understood that a low-temperature plasma such as in sputtering has difficulty in controlling the structure of the active material layer, whereas thermal plasma allows easy control of the structure of the active material layer. It is understood, therefore, that by using the production method of the present invention, it is possible to form an electrode with a high film growth rate, and it is easy to control the structure of the active material layer.

It should be noted that similar results as in Example 3 were obtained in every case where lithium hydroxide or lithium carbonate was used as the lithium compound for the raw material. Further, the same results as in Example 3 were obtained in every case where cobalt oxide, cobalt carbonate, cobalt nitrate or cobalt hydroxide was used as the cobalt compound for the raw material.

Similar results were obtained when one selected from the group consisting of nickel oxide, nickel carbonate, nickel nitrate, nickel hydroxide, and nickel oxyhydroxide was used as the nickel compound, and the nickel compound, cobalt compound, and lithium compound were mixed such that Li:Ni:Co = 1.5:0.5:0.5, whereby an active material layer containing LiNi_{0.5}Co_{0.5}O₂ was formed.

Similar results were obtained when the lithium compound, nickel compound, and manganese compound were mixed such that Li:Ni:Mn = 1.5:0.5:0.5, whereby an active material layer containing LiNi_{0.5}Mn_{0.5}O₂ was formed.

Similar results were obtained when the lithium compound, nickel compound, and iron compound were mixed such that Li:Ni:Fe = 1.5:0.5:0.5, whereby an active material layer containing LiNi_{0.5}Fe_{0.5}O₂ was formed.

Similar results were obtained when the lithium compound, nickel compound, manganese compound, and cobalt compound were mixed such that Li:Ni:Mn:Co = 1.5:1/3:1/3:1/3, whereby an active material layer containing LiNi_{1/3}Mn_{1/3}Co_{1/3}O₂ was formed.

Similar results were obtained when the lithium compound and Nb₂O₅ were mixed so that Li:Nb = 1.5:1 to form an active material containing LiNbO₃.

It should be further noted that Similar results were obtained in every case where LiNi_{0.5}Co_{0.5}O₂, LiNi_{0.5}Mn_{0.5}O₂, LiNi_{0.5}Fe_{0.5}O₂, LiNi_{1/3}Mn_{1/3}Co_{1/3}O₂, LiNbO₃, LiFePO₄, LiCoPO₄, Nb₂O₅, V₂O₅, SnO_{α}, Li_{4/3}Ti_{5/3}O₄, MoO₂, SiO, or PbO was used as the raw material.

### Industrial Applicability

According to the production method of the present invention, it is possible to provide a high capacity electrode for a non-aqueous electrolyte secondary battery in a highly productive manner. Therefore, the present invention is useful as a method for producing an electrode for a non-aqueous electrolyte secondary battery used in various applications ranging from portable electronic devices such as cellular phones to large-sized electronic devices.

## Claims

1. A method for producing an electrode for a non-aqueous electrolyte secondary battery, the method comprising the steps of
(a) generating a thermal plasma,
(b) supplying a raw material of active material into the thermal plasma, and
(c) depositing particles produced in the thermal plasma on a surface of a current collector to give an active material layer.

2. The method for producing an electrode for a non-aqueous electrolyte secondary battery in accordance with claim 1, wherein the step (a) includes generating the thermal plasma in an atmosphere containing at least one gas selected from the group consisting of argon, helium, oxygen, hydrogen, and nitrogen.

3. The method for produdng an electrode for a non-aqueous electrolyte secondary battery in accordance with claim 1 or 2, wherein the atmosphere for generating the thermal plasma has a pressure of 10² to 10⁶ Pa.

4. The method for producing an electrode for a non-aqueous electrolyte secondary battery in accordance with any one of daims 1 to 3, wherein the step (a) includes generating the thermal plasma by applying a high frequency to a coil from an RF power source.

5. The method for produdng an electrode for a non-aqueous electrolyte secondary battery in accordance with any one of daims 1 to 4, wherein the raw material is supplied in a powder state into the thermal plasma.

6. The method for produdng an electrode for a non-aqueous electrolyte secondary battery in accordance with any one of daims 1 to 5, wherein the raw material contains a transition metal compound.

7. The method for producing an electrode for a non-aqueous electrolyte secondary battery in accordance with claim 6, wherein the raw material further contains a lithium compound.

8. The method for producing an electrode for a non-aqueous electrolyte secondary battery in accordance with any one of claims 1 to 5, wherein the raw material contains a lithium-containing transition metal oxide.

9. The method for producing an electrode for a non-aqueous electrolyte secondary battery in accordance with any one of daims 1 to 5, wherein the raw material contains at least one selected from the group consisting of Si, Sn, and Pb.

10. The method for producing an electrode for a non-aqueous electrolyte secondary battery in accordance with any one of daims 1 to 9, wherein information on a relationship between a supply rate of the raw material into the thermal plasma and a structure of an active material layer is obtained in advance, and in the step (b), the supply rate of the raw material into the thermal plasma is controlled on the basis of the obtained information.

11. The method for producing an electrode for a non-aqueous electrolyte secondary battery in accordance with any one of daims 1 to 10, wherein information on a relationship between a temperature of the thermal plasma in a vicinity of the current collector and a structure of an active material layer is obtained in advance, and in the step (a), the temperature of the thermal plasma in a vicinity of the current collector is controlled on the basis of the obtained information.
